(19) Europäisches Patentamt / European Patent Office / Office européen des brevets

(11) **EP 3 583 239 B1**

(12) **EUROPÄISCHE PATENTSCHRIFT**

(45) Veröffentlichungstag und Bekanntmachung des Hinweises auf die Patenterteilung:
**19.05.2021   Patentblatt 2021/20**

(21) Anmeldenummer: **18714694.9**

(22) Anmeldetag: **16.02.2018**

(51) Int Cl.:
**B32B 15/01** [(2006.01)]   **C21D 9/48** [(2006.01)]
**C22C 38/00** [(2006.01)]   **C23C 2/06** [(2006.01)]
**C23C 30/00** [(2006.01)]   **C25D 3/22** [(2006.01)]
**C25D 3/56** [(2006.01)]   **C25D 5/36** [(2006.01)]
**C21D 8/02** [(2006.01)]   **C21D 8/04** [(2006.01)]
**C22C 38/02** [(2006.01)]   **C22C 38/04** [(2006.01)]
**C22C 38/06** [(2006.01)]   **C22C 38/12** [(2006.01)]
**C22C 38/14** [(2006.01)]

(86) Internationale Anmeldenummer:
**PCT/EP2018/053885**

(87) Internationale Veröffentlichungsnummer:
**WO 2018/149967 (23.08.2018 Gazette 2018/34)**

(54) **VERFAHREN ZUM HERSTELLEN VON STAHLBLECHEN, STAHLBLECH UND DESSEN VERWENDUNG**

METHOD FOR PRODUCING STEEL SHEETS, STEEL SHEET AND USE THEREOF

PROCÉDÉ DE FABRICATION DE TÔLES D'ACIER, TÔLE D'ACIER ET SON UTILISATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.02.2017   DE 102017103299**
**17.02.2017   DE 102017103303**

(43) Veröffentlichungstag der Anmeldung:
**25.12.2019   Patentblatt 2019/52**

(73) Patentinhaber: **voestalpine Stahl GmbH**
**4020 Linz (AT)**

(72) Erfinder:
• **STÖGMÜLLER, Markus**
**4061 Pasching (AT)**
• **PAESOLD, Dieter**
**4501 Neuhofen (AT)**
• **HEBESBERGER, Thomas**
**4061 Pasching (AT)**

(74) Vertreter: **HGF**
**Neumarkter Straße 18**
**81673 München (DE)**

(56) Entgegenhaltungen:
**WO-A1-2016/055227     DE-A1-102012 017 703**

• **BASJAN BERKHOUT: "PREMIUM PAINT APPEARANCE: SERICA , THE HOT-DIP GALVANISED SURFACE FINISH FOR EXPOSED AUTOMOTIVE PANELS", INTERNATIONAL PAINT&COATING MAGAZINE, Nr. 34, 31. August 2015 (2015-08-31), Seiten 92-96, XP055471246,**
• **Stahl Wirtschaftsvereinigung: "Continuously Hot-Dip Coated Steel Strip and Sheet Characteristic Properties 095 - E", , 31. Dezember 2017 (2017-12-31), XP055471249, Gefunden im Internet: URL:http://www.stahl-online.de/wp-content/uploads/2013/10/CM-095E_Continuously-Hot-Dip-Coated-Steel-Strip-and-Sheet_final.pdf [gefunden am 2018-04-27]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft ein Verfahren zur Herstellung von Stahlblechen mit einer verbesserten optischen Güte nach dem Umformen.

Um das optische Erscheinungsbild von Automobilen im lackierten Zustand weiter zu verbessern, wurde herausgefunden, dass die Anpassung der Bandtopographie zur Verbesserung der Lackanmutung zwar wichtig, aber nicht ausreichend ist. Eine Vielzahl von Parametern ist für ein gutes Lackerscheinungsbild beim Fertigen von geformten und lackierten Blechen maßgeblich.

Eine wesentliche Maßzahl für eine gute Lackierbarkeit und eine gute Lackanmutung ist der sogenannte Wave-Surface-Arithmetic-Value (Wsa). In www.blechnet.com "Neuartige Blechverzinkung bringt Automobillack auf Hochglanz", 17. Oktober 2013, wird ausgeführt, dass ein Wsa-Wert der Bleche unter 0,35 $\mu$m für gute Lackanmutung sorgt. Ein niedriger Wsa-Wert würde zunächst gute Lackanmutung bedeuten. Weil der Wsa-Wert zugleich mit der mittleren Rauheit (Ra) korreliere, würde auch die Umformfähigkeit beeinflusst. Es wird ausgeführt, dass es in der Praxis darauf ankäme, den Wsa-Wert der Bleche unter 0,35 $\mu$m zu senken, wobei bei herkömmlichen Blechen der Wsa durchaus über 0,5 $\mu$m liegen würde, und gleichzeitig genügend Schmiertaschen für die Umformung zur Verfügung zu stellen, was durch die Erhöhung der sogenannten Spitzenzahl gelänge.

Hierbei wird darauf abgestellt, mit der Dressierwalze ähnlich wie in der Drucktechnik die spätere Topografie des Blechs als negative Zugabe vorweg zu nehmen. Um die oben genannten Wsa-Werte zu erreichen, wurden neue Walzentexturen hergestellt, zudem wurden thermische Prozesse in den Ofen verbessert.

Ein vergleichbarer Bericht ist von thyssenkrupp Steel Europe unter www.besserlackieren.de veröffentlicht, in dem ebenfalls beschrieben wird, dass die Oberflächenbearbeitung des verzinkten Blechs eine entsprechende Güte ermöglicht.

Aus der EP 0 234 698 B1 ist z. B. ein Verfahren bekannt, bei dem eine Oberflächenrauheit mit definierten Erhebungsbereichen erzeugt wird.

Das elektrolytische Verzinken oder auch Aufdampfen (PVD, CVD, ...) ist neben dem Schmelztauchverzinken eine Möglichkeit, einen kathodischen zinkbasierten Korrosionsschutz auf Stahlblech aufzubringen. Während beim Schmelztauchverzinken das Band durch ein flüssiges Zinkbad hindurch geführt wird (ca. 450°C), findet das elektrolytische Verzinken oder Aufbringen von Zink durch Aufdampfen bei niedrigeren Temperaturen (unter 100°C bzw. 300°C) statt.

Vergleicht man die Oberflächen einer elektrolytischen Verzinkung oder aufgedampften Zinkschicht mit einer Schmelztauchverzinkungsoberfläche erkennt man, dass diese sich unterscheiden, insbesondere weist die elektrolytische Verzinkung eine große Gleichmäßigkeit auf, die jedoch bei ultrahoher Vergrößerung als Mikrorauigkeit erkennbar ist.

Grundsätzlich verläuft die Herstellung von verzinkten Stahlblechen derart, dass aus Roheisen im Konverter Stahl erzeugt wird, der in einer Stranggussanlage vergossen wird, anschließend in einer Warmbreitbandstraße gewalzt wird und anschließend kalt gewalzt wird. Bei elektrolytischen Verzinkungsverfahren oder beim Aufdampfen von Zink erfolgt vor dem Verzinken ein Glühen und gegebenenfalls Dressieren und anschließen die elektrolytische Verzinkung oder das Aufdampfen von Zink, wobei nach der Verzinkung noch eine weitere Beschichtung, beispielsweise eine Phosphatierung, stehen kann.

Aus der ÖNORM EN10152 sind kontinuierlich elektrolytisch verzinkte Flacherzeugnisse aus niedrig legiertem Stahl zum Kaltumformen bekannt.

Die dort genannten Stähle sind durchgehend niedriglegierte Stähle.
Insbesondere werden im Automobilbereich in der Außenhaut IF- und BH-Stähle eingesetzt.

Unter einem IF-Stahl versteht man einen "Interstitial Free"-Stahl, der keine interstitiell eingelagerten Fremdatome besitzt (die geringen Gehalte an Kohlenstoff und Stickstoff sind vollständig durch Titan und/oder Niob als Karbide bzw. Nitride abgebunden) und damit eine hervorragende plastische Umformbarkeit besitzt. Derartige Stähle werden für Tiefziehteile im Automobilbau eingesetzt.

Bake-Hardening Stähle (BH-Stähle) zeichnen sich durch einen signifikanten Anstieg der Streckgrenze im Zuge des Lackeinbrennens (typischerweise bei 170°C für 20min) in Kombination mit einer sehr guten Umformbarkeit aus. Weiters besitzen diese Stähle eine sehr gute Beulsteifigkeit, weswegen diese Stähle gerne für Außenhautanwendungen verwendet werden.

Aufgabe der Erfindung ist es, ein Verfahren zur Herstellung von Stahlblechen aus IF-Stahl in unbeschichtetem Zustand oder nach einer zusätzlichen elektrolytischen Beschichtung oder auch in CVD- oder DVD-Verfahren aufgebrachten Schritte mit einem metallischen Überzug wie Zn, ZnNi, ZnCr oder einem anderen dem Korrosionsschutz dienenden metallischen Überzug zu schaffen, mit dem die gewünschten Wsa-Werte im verformten Zustand besser erreicht werden und die Bereiche sicher gehalten werden können.

Die Aufgabe wird mit einem Verfahren mit den Merkmalen des Anspruchs 1 gelöst.

Vorteilhafte Weiterbildungen sind in den Unteransprüchen gekennzeichnet.

Die Messung der Wsa-Werte erfolgte an Marciniak-Streckziehproben mit 5% Verformung in Anlehnung an SEP1941, aber in Walzrichtung.

Erfindungsgemäß wurde festgestellt, dass allein durch die Optimierung der Langwelligkeit im unverformten Zustand der Wsa-Wert von Außenhautteilen im verformten Zustand nicht zuverlässig und sicher im gewünschten Bereich <0,35 μm gehalten werden kann.

Erfindungsgemäß wurde festgestellt, dass die sichere Einhaltung der geforderten Langwelligkeitsgrenzen im verformten Zustand durch gezielte Maßnahmen am Werkstoff möglich ist.

Das heißt, dass speziell durch eine Änderung der Legierungszusammensetzung bei den verwendeten IF-Stählen eine fertigungssichere Produktion von Außenhautmaterialien mit reduzierter Langwelligkeit im verformten Zustand erreicht werden kann.

Dementsprechend wurde erfindungsgemäß herausgefunden, dass eine gesicherte Einstellung von reduzierter Langwelligkeit im verformten Zustand insbesondere bei IF-Stählen durch das Zulegieren von Niob mit Gehalten >= 0,02 Gew.-% erreichbar ist. Insbesondere kann z. B. die Stahlsorten DC04 bis DC07 hiermit mit einem Wsa-Wert auf einem Niveau unter 0,30 μm stabilisiert werden.

Wird bei einem Einsatz von IF-Stählen anstatt des üblichen Titan-Konzeptes für Außenhautbleche ein Titan-Niob-Konzept verwendet, kann das Wsa-Niveau auf im Mittel 0,29 μm stabilisiert werden.

Als Vorteil hat sich auch erwiesen, dass bei Zugabe von Nb zum Stahl die Aufheizraten für das Rekristallisationsglühen in einem weiten Bereich variiert werden können, ohne den Wsa-Wert in negativer Weise zu beeinflussen. Diese betragen erfindungsgemäß von 5 bis 30 K/s.

Der dem rekristallisierenden Glühen folgende Dressier- oder Nachwalzvorgang dient der Einstellung der mechanischen Eigenschaften und der gezielten Beeinflussung der Oberflächenrauheit. Im Zuge dieses Vorganges wird sowohl Rauheit als auch Langwelligkeit von der Walze auf das Band übertragen.

Die Erfindung wird anhand einiger Zeichnungen beispielhaft erläutert. Es zeigen hierbei:

Figur 1:    Die Gegenüberstellung der Langwelligkeit bei dressiertem IF-Stahl in unbeschichtetem Zustand nach dem Stand der Technik (bis Beispiel 48) gegen die erfindungsgemäß verbesserten Wsa-Werte jeweils vor und nach der Verformung (ab Beispiel 49);

Figur 2:    Den Zusammenhang zwischen dem Niob-Gehalt im Grundmaterial (IF-Stahl dressiert) und den gemessenen Wsa-Werten im verformten Zustand;unbeschichtet;

Figur 3:    Die Gegenüberstellung der Langwelligkeit bei dressiertem IF-Stahl in unbeschichtetem Zustand und im elektrolytisch verzinktem Zustand nach Verformung;

Figur 4:    Die erfindungsgemäße Legierung als Tabelle;

Figur 5:    Eine Tabelle zeigend einen bevorzugten Legierungsteilbereich;

Figur 6:    Eine Tabelle zeigend einen besonders bevorzugten Legierungsteilbereich.

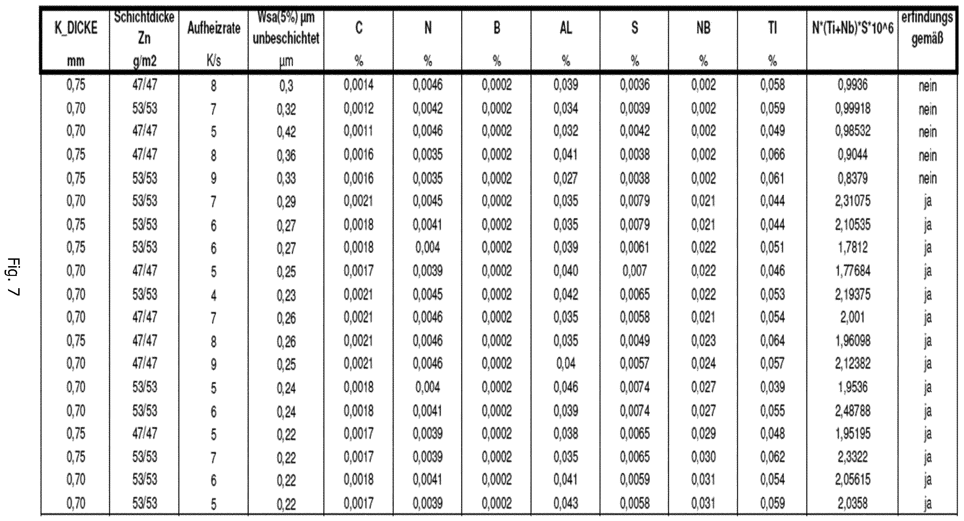

Figur 7:    Eine Tabelle zeigend einige Ausführungsbeispiele; erfindungsgemäße als auch Vergleichsbeispiele

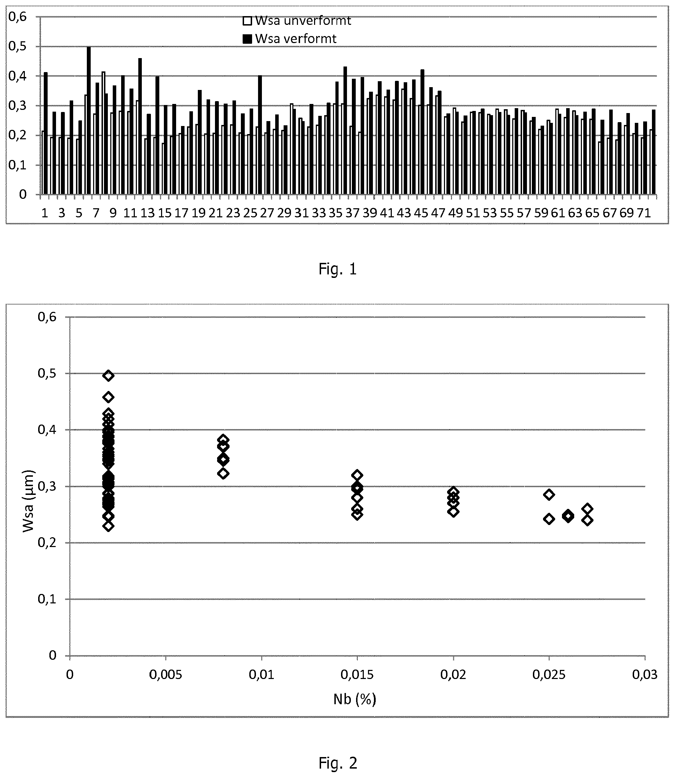

In Figur 1 sieht man einen handelsüblichen IF-Stahl, welcher nach dem Stand der Technik hergestellt und verarbeitet wurde (bis Beispiel 48). Man erkennt die erhebliche Streuung der Wsa-Werte im Zuge der Verformung. Ab Beispiel 49 handelt es sich um IF-Stähle gemäß der Erfindung mit erheblich verbesserten Wsa-Werten und einer deutlich geringeren Streuung. Man erkennt, dass mit der Erfindung die Werte gesichert um oder unter 0,30 μm gehalten werden können. Hierbei sind die hellen Balken die Wsa-Werte für den unverformten Zustand und die schwarzen Balken die Werte für den verformten Zustand.

Figur 2 macht den Zusammenhang zwischen dem Niob-Gehalt im Grundmaterial (IF-Stahl) und den gemessenen Wsa-Werten am dressierten unbeschichteten Stahl im verformten Zustand deutlich. Mit zunehmendem Gehalt an Nb wird nicht nur der Wsa-Wert niedriger, auch die Streuung nimmt signifikant ab.

Erfindungsgemäß wird in der Legierung ein Niob-Gehalt >0,01 Gew.-% (= 100 ppm) eingestellt. Erfindungsgemäß wird bevorzugt der Niob-Gehalt auf 0,011 bis 0,10 Gew.-% eingestellt, weiter bevorzugt auf 0,011-0,05 Gew.-%. Mit diesen Werten können ausgesprochen gute Wsa-Werte erzielt werden.

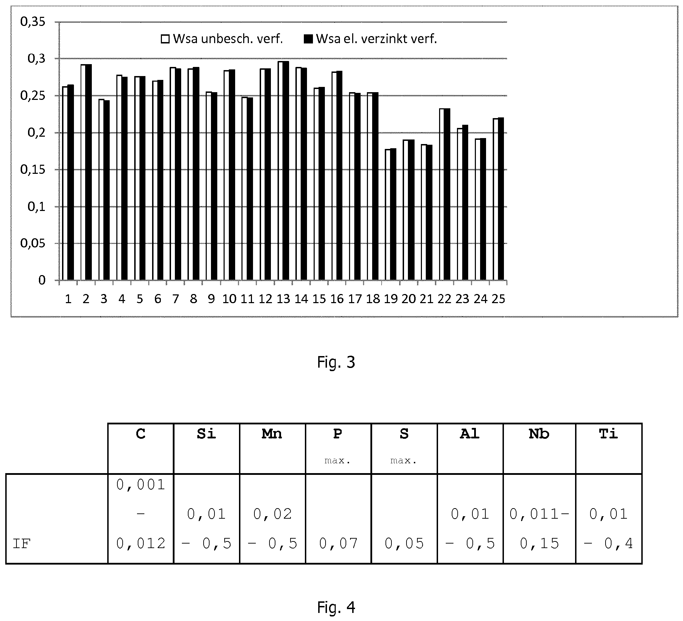

Figur 3 lässt erkennen, dass die Änderung des Wsa-Wertes durch den Verzinkungsvorgang nahezu nicht gegeben ist.

Durch den Einsatz geeigneter Dressierwalzen ist es möglich, die Welligkeitswerte des metallisch beschichteten Bandes im unverformten Zustand auf ein geringes Niveau zu reduzieren. Diese Verbesserung lässt sich jedoch im verformten Zustand nicht mehr darstellen.

Der Dressiergrad beträgt zwischen 0,5 und 0,75%.

Durch die Zugabe von Nb konnte erreicht werden, dass kein oder kaum ein Anstieg der Wsa-Werte durch die Verformung gegeben ist.

Insbesondere nach der Verformung zeigen die erfindungsgemäß produzierten IF-Stähle erheblich bessere Eigenschaften als handelsübliche IF-Stähle nach dem Stand der Technik.

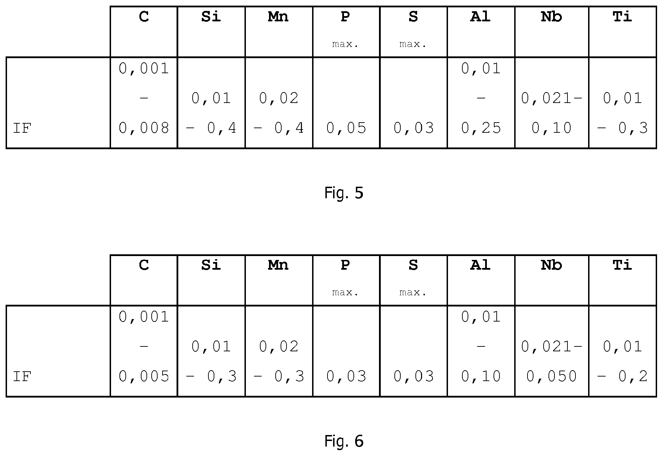

Erfindungsgemäß kann der IF-Stahl die Legierungszusammensetzung nach Anspruch 1 aufweisen (alle Werte in Gewichtsprozent):
Bevorzugt weist der IF-Stahl teilweise die Zusammensetzung nach Fig. 5 auf: Besonders bevorzugter Teilbereich des IF-Stahles ist in Fig. 6. gezeigt: Rest jeweils Eisen und erschmelzungsbedingte Verunreinigungen.

In Figur 2 ist der entsprechende gemessene Zusammenhang am IF-Stahl ersichtlich, welcher die Wsa-Werte nach Verformung über dem Niob-Gehalt anzeigt. Hierbei ist eine stetige Verbesserung des Wsa-Wertes mit Zunahme des Nb-Gehaltes erkennbar. Dieser Zusammenhang ist vermutlich auch beim Zulegieren über 0,03 Gew.-% Niob hinaus gegeben. Jedoch ermöglichen die erfindungsgemäßen Bereiche einerseits eine ausreichende Wsa-Wertabsenkung und verhindern andererseits unerwünschte Verfestigungseffekte beim Grundmaterial, welche zu einer Verringerung der Umformbarkeit führen würden.

Für eine geringe Langwelligkeit im unverformten und in weiterer Folge im verformten Zustand wird die Walzenrauheit (Ra) für den Dressiervorgang auf Werte zwischen 1,6 und 3,3 $\mu$m eingestellt, um die vom Kunden geforderten Rauheitswerte am Band einhalten zu können. Eine weitere Absenkung der Wsa-Werte ist durch Absenkung der Walzenrauheiten möglich, würde aber eine Absenkung der kundenseitigen Rauheitsvorgaben bedingen.

Als Beschichtungsmaterial beim elektrolytischen Abscheidevorgang sind alle üblichen metallischen Überzugsmaterialien nach dem Stand der Technik möglich. Dies sind insbesondere aber nicht ausschließlich Zinklegierungen.

Bei der Erfindung ist von Vorteil, dass es durch Maßnahmen innerhalb des Legierungskonzeptes im Stahl gelingt, den Wsa-Wert auf einem sehr niedrigen Niveau sehr stabil darzustellen.

Die folgenden Beispiele sollen den positiven Einfluss des Niobgehaltes auf die Ausbildung des Wsa-Werteniveaus am umgeformten Bauteil (gemessen an Marciniak-Streckziehproben mit 5% Verformung) darstellen und diesen von anderen Einflüssen abgrenzen.

Bei den im Folgenden aufgelisteten Beispielen für die Beschichtungsvarianten Z wurden der Vollständigkeit halber Bandgeschwindigkeiten und Abscheidebedingungen mit angegeben. Sie liegen alle innerhalb der nach dem Stand der Technik üblichen Parameter, haben jedoch keinen signifikanten Einfluss auf die Wsa-Werte im verformten Zustand.

Fig 1: Beispiele von an IF-Stahlen gemessenen Wsa-Werten nach dem Stand der Technik (bis Beispiel 48) und gemäß vorliegender Erfindung (ab Beispiel 49)

Es hat sich herausgestellt, dass es vorteilhaft ist, die folgende Bedingung einzuhalten:

$$N*(Ti+Nb)*S*10^6$$

Unter der Maßgabe, dass
bei reinen Zinküberzügenen (Z) das Produkt >1 und bei Zink-Magnesium-Überzügen (ZM) >2 ist.

Erfindungsgemäß kann damit sicher gestellt werden, dass gröbere Ausscheidungen gebildet werden. Dies führt zu einer besseren Umformbarkeit ohne negative Auswirkungen auf die Festigkeit auszuüben.

Fig 2: Zusammenhang zwischen Nb-Gehalt im Stahl und den Wsa-Werten nach Verformung

Fig 3: Wsa-Werte am unbeschichteten Stahl und nach elektrolytischer Verzinkung

**Patentansprüche**

1. Verfahren zum Herstellen von Stahlblech, insbesondere für Außenhautbleche von Fahrzeugen, wobei eine Stahllegierung einer gewünschten Zusammensetzung erschmolzen, vergossen und anschließend zu Blech gewalzt wird, wobei die Stahllegierung ein

    A) Interstitial Free-Stahl (IF-Stahl)
    ist und das Stahlblech nach dem Walzen
    B) geglüht und dressiert wird,

    **dadurch gekennzeichnet, dass** dem Stahl zur Erzielung eines Wsa-Wertes von unter 0,35 $\mu$m mit möglichst enger Streuung Niob mit einem Gehalt >0,01 Gew.-%, bevorzugt >0,011 Gew.-% besonders bevorzugt > 0,02 Gew.-%, zulegiert wird, wobei die Legierung die folgende Bedingung erfüllt: $N*(Ti+Nb)*S*10^6$, wobei das Produkt größer 1 bevorzugt größer 1,5 ist, wobei die Stahllegierung die folgende Analyse aufweist:

| | | | |
|---|---|---|---|
| C | 0,001-0,015 | bevorzugt 0,001-0,010 | weiter bevorzugt 0,001-0,005 |
| Si | 0,01-0,5 | bevorzugt 0,01-0,4 | weiter bevorzugt 0,01-0,3 |

(fortgesetzt)

| | | | |
|---|---|---|---|
| Mn | 0,02 bis 0,5 | bevorzugt 0,02-0,4 | weiter bevorzugt 0,02-0,3 |
| P | max. 0,1 | bevorzugt max. 0,05 | weiter bevorzugt max. 0,05 |
| S | max. 0,05 | bevorzugt max. 0,03 | weiter bevorzugt max. 0,03 |
| Al | 0,01 bis 1,0 | bevorzugt 0,01-0,50 | weiter bevorzugt 0,01-0,1 |
| Nb | 0,011 bis 0,15 | bevorzugt 0,011-0,10 | weiter bevorzugt 0,011-0,05 |
| Ti | 0,01 bis 0,4 | bevorzugt 0,01-0,3 | weiter bevorzugt 0,01-0,20 |

Optional eines oder mehrere folgender Elemente:

Bor bis max. 100 ppm und/oder
Vanadium bis 0,4 Gew.-% und/oder
Zirkonium bis 0,4 Gew.-% und/oder
Hafnium bis 0,5 Gew.-%, und/oder
Wolfram bis 0,5 Gew.-%, und/oder
Tantal bis 0,5 Gew.-%,
Rest Eisen und erschmelzungsbedingte Verunreinigungen.

2. Verfahren nach Anspruch 1, **dadurch gekennzeichnet, dass** ein IF-Stahl mit der folgenden Analyse in Gew.-% erschmolzen wird:

| | | | |
|---|---|---|---|
| C | 0,001-0,015 | bevorzugt 0,001-0,010 | weiter bevorzugt 0,001-0,005 |
| Si | 0,01-0,5 | bevorzugt 0,01-0,4 | weiter bevorzugt 0,01-0,3 |
| Mn | 0,02 bis 0,5 | bevorzugt 0,02-0,4 | weiter bevorzugt 0,02-0,3 |
| P | max. 0,1 | bevorzugt max. 0,05 | weiter bevorzugt max. 0,05 |
| S | max. 0,05 | bevorzugt max. 0,03 | weiter bevorzugt max. 0,03 |
| Al | 0,01 bis 1,0 | bevorzugt 0,01-0,50 | weiter bevorzugt 0,01-0,1 |
| Nb | 0,011 bis 0,15 | bevorzugt 0,011-0,10 | weiter bevorzugt 0,011-0,05 |
| Ti | 0,01 bis 0,4 | bevorzugt 0,01-0,3 | weiter bevorzugt 0,01-0,20 |

Optional eines oder mehrere folgender Elemente:

Bor bis max. 100 ppm und/oder
Vanadium bis 0,4 Gew.-% und/oder
Zirkonium bis 0,4 Gew.-% und/oder
Hafnium bis 0,5 Gew.-%, und/oder
Wolfram bis 0,5 Gew.-%, und/oder
Tantal bis 0,5 Gew.-%,
Rest Eisen und erschmelzungsbedingte Verunreinigungen.

3. Verfahren nach Anspruch 1 oder 2, **dadurch gekennzeichnet, dass** ein IF-Stahl mit der folgenden Analyse in Gew.-% erschmolzen wird:

| | | | |
|---|---|---|---|
| C | 0,001 bis 0,015 | bevorzugt 0,001-0,010 | weiter bevorzugt 0,001-0,006 |
| Si | 0,01-0,5 | bevorzugt 0,01-0,4 | |
| Mn | 0,02 bis 0,5 | | |
| P | max. 0,1 | bevorzugt max. 0,1 | weiter bevorzugt max. 0,1 |
| S | max. 0,05 | bevorzugt max. 0,03 | weiter bevorzugt max. 0,03 |
| Al | 0,015 bis 1,0 | bevorzugt 0,015-0,5 | weiter bevorzugt 0,015-0,10 |
| Nb | 0,02 bis 0,15 | bevorzugt 0,021-0,10 | weiter bevorzugt 0,021-0,05 |
| Ti | 0,01 bis 0,2 | bevorzugt 0,01-0,15 | weiter bevorzugt 0,01-0,12 |

Optional eines oder mehrere folgender Elemente:

Bor bis max. 100 ppm und/oder
Vanadium bis 0,4 Gew.-% und/oder
Zirkonium bis 0,4 Gew.-%, und/oder
Hafnium bis 0,5 Gew.-%, und/oder
Wolfram bis 0,5 Gew.-%, und/oder
Tantal bis 0,5 Gew.-%, und/oder

Rest Eisen und erschmelzungsbedingte Verunreinigungen

4. Verfahren nach einem der vorhergehenden Ansprüche, **dadurch gekennzeichnet, dass** nach dem Dressieren das Stahlblech durch ein elektrolytisches Verfahren oder durch Aufdampfen mit einer metallischen Korrosionsschutzschicht versehen wird.

5. Verfahren nach Anspruch 4, **dadurch gekennzeichnet, dass** die metallische Korrosionsschutzschicht elektrolytisch aufgetragen oder mit CVD- oder PVD-Verfahren aufgebraucht ist, wobei der metallische Überzug aus Zink oder auf der Basis von Zink ist, insbesondere ein Zink-Chrom-Überzug, ein Zink-Nickel-Überzug, ein Zink-Magnesium, ein Zink-Titan, ein Zink-Kalzium oder auch Zink-Legierungen mit Zirkon, Hafnium, Cer oder auch generell Mischmetallen bzw. Metallen aus seltenen Erden.

6. Verfahren nach einem der vorgehenden Ansprüche, **dadurch gekennzeichnet, dass** Dressierwalzen mit einer Rauheit (Ra) von 1,6 bis 3,3 $\mu$m verwendet werden.

7. Verfahren nach einem der vorhergehenden Ansprüche, **dadurch gekennzeichnet, dass** der Dressiergrad zwischen 0,5 und 0,75% beträgt.

8. Verfahren nach einem der vorhergehenden Ansprüche, **dadurch gekennzeichnet, dass** die Aufheizrate zwischen 5 K/s und 30 K/s liegen dürfe.

9. Stahlblech hergestellt mit einem Verfahren nach einem der vorhergehenden Ansprüche mit einer Zusammensetzung gemäß Anspruch 2 oder Anspruch 3.

10. Verwendung eines Stahlblechs nach Anspruch 9 für Außenhautteile von Kraftfahrzeugen und Gebäuden.

## Claims

1. Method for manufacturing sheet steel, in particular for outer skin panels of vehicles, wherein a steel alloy of desired composition is melted, cast and then rolled into a sheet, wherein the steel alloy is

   A) an interstitial free steel (IF steel) and, after rolling, the sheet steel
   B) is annealed and skin passed,

   **characterised in that**, in order to attain a Wsa value of under 0.35 $\mu$m, the steel is alloyed with the narrowest possible dispersion of niobium with a content >0.01 % w/w, preferably >0.011 % w/w, particularly preferably > 0.02 % w/w, wherein the alloy fulfils the following condition: N*(Ti+Nb)*S*10^6, wherein the product is greater than 1, preferably greater than 1.5, wherein the steel alloy has the following analysis:

   | | | | |
   |---|---|---|---|
   | C | 0.001-0.015 | preferably 0.001-0.010 | more preferably 0.001-0.005 |
   | Si | 0.01-0.5 | preferably 0.01-0.4 | more preferably 0.01-0.3 |
   | Mn | 0.02 up to 0.5 | preferably 0.02-0.4 | more preferably 0.02-0.3 |
   | P | max. 0.1 | preferably max. 0.05 | more preferably max. 0.05 |
   | S | max. 0.05 | preferably max. 0.03 | more preferably max. 0.03 |
   | Al | 0.01 up to 1.0 | preferably 0.01-0.50 | more preferably 0.01-0.1 |
   | Nb | 0.011 up to 0.15 | preferably 0.011-0.10 | more preferably 0.011-0.05 |
   | Ti | 0.01 up to 0.4 | preferably 0.01-0.3 | more preferably 0.01-0.20 |

optionally one or more of the following elements:

Boron up to max. 100 ppm and/or
Vanadium up to 0.4 % w/w and/or
Zirconium up to 0.4 % w/w and/or
Hafnium up to 0.5 % w/w, and/or
Tungsten up to 0.5 % w/w, and/or
Tantalum up to 0.5 % w/w,
the remainder being iron and melting-related impurities.

2. Method according to claim 1, **characterised in that** an IF steel with the following analysis in % w/w is melted:

| | | | |
|---|---|---|---|
| C | 0.001-0.015 | preferably 0.001-0.010 | more preferably 0.001-0.005 |
| Si | 0.01-0.5 | preferably 0.01-0.4 | more preferably 0.01-0.3 |
| Mn | 0.02 up to 0.5 | preferably 0.02-0.4 | more preferably 0.02-0.3 |
| P | max. 0.1 | preferably max. 0.05 | more preferably max. 0.05 |
| S | max. 0.05 | preferably max. 0.03 | more preferably max. 0.03 |
| Al | 0.01 up to 1.0 | preferably 0.01-0.50 | more preferably 0.01-0.1 |
| Nb | 0.011 up to 0.15 | preferably 0.011-0.10 | more preferably 0.011-0.05 |
| Ti | 0.01 up to 0.4 | preferably 0.01-0.3 | more preferably 0.01-0.20 |

optionally one or more of the following elements:

Boron up to max. 100 ppm and/or
Vanadium up to 0.4 % w/w and/or
Zirconium up to 0.4 % w/w and/or
Hafnium up to 0.5 % w/w, and/or
Tungsten up to 0.5 % w/w, and/or
Tantalum up to 0.5 % w/w,
the remainder being iron and melting-related impurities.

3. Method according to claims 1 or 2, **characterised in that** an IF steel with the following analysis in % w/w is melted:

| | | | |
|---|---|---|---|
| C | 0.001 up to 0.015 | preferably 0.001-0.010 | more preferably 0.001-0.006 |
| Si | 0.01 up to 0.5 | preferably 0.01-0.4 | |
| Mn | 0.02 up to 0.5 | | |
| P | max 0.1 | preferably max. 0.1 | more preferably max. 0.1 |
| S | max. 0.05 | preferably max. 0.03 | more preferably max. 0.03 |
| Al | 0.015 up to 1.0 | preferably 0.015-0.5 | more preferably 0.015-0.10 |
| Nb | 0.02 up to 0.15 | preferably 0.021-0.10 | more preferably 0.021-0.05 |
| Ti | 0.01 up to 0.2 | preferably 0.01-0,15 | more preferably 0.01-0.12 |

optionally one or more of the following elements:

Boron up to max. 100 ppm and/or
Vanadium up to 0.4 % w/w and/or
Zirconium up to 0.4 % w/w, and/or
Hafnium up to 0.5 % w/w, and/or
Tungsten up to 0.5 % w/w, and/or
Tantalum up to 0.5 % w/w, and/or
the remainder being iron and melting-related impurities.

4. Method according to any one of the preceding claims, **characterised in that**, after skin passing, the sheet steel is provided with a metallic corrosion protective layer by an electrolytic method or by evaporation deposition.

5. Method according to claim 4, **characterised in that** the metallic corrosion protective layer is deposited electrolytically or is deposited using the CVD- or PVD method wherein the metallic top coating is zinc or is based on zinc, in particular a coating of zinc-chrome, zinc-nickel, an alloy of zinc-magnesium, zinc-titanium, zinc-calcium or even zinc alloys with zirconium, hafnium, cerium or also generally mixed metals or metals from rare earths.

6. Method according to any one of the preceding claims, **characterised in that** skin-pass rollers are used with a roughness (Ra) of 1.6 up to 3.3 $\mu$m.

7. Method according to any one of the preceding claims, **characterised in that** the skin-pass level is between 0.5 and 0.75%.

8. Method according to any one of the preceding claims, **characterised in that** the rate of heating up may be between 5 K/sec and 30 K/sec.

9. Sheet steel produced with a method according to any one of the preceding claims with a composition according to claim 2 or claim 3.

10. Use of a sheet steel according to claim 9 for outer skin parts of motor vehicles and buildings.

**Revendications**

1. Procédé de fabrication de tôle d'acier, en particulier pour les tôles de revêtement des véhicules, où un acier allié d'une composition souhaitée est fondu, coulé et ensuite laminé pour obtenir des tôles, où l'acier allié est un

A) acier Interstitial Free (acier IF) et la tôle d'acier après le laminage
B) est calciné et dressé,

**caractérisé en ce que**, pour obtenir une valeur Wsa inférieure à 0,35 $\mu$m avec une dispersion la plus étroite possible, du niobium d'une teneur >0,01 % en poids, de préférence >0,011 % en poids, de manière particulièrement préférée > 0,02 % en poids est allié à l'acier, l'alliage remplissant la condition suivante : N*(Ti+Nb)*S*10^6, où le produit est supérieur à 1, de préférence supérieur à 1,5, l'acier allié présentant l'analyse suivante :

| | | | |
|---|---|---|---|
| C | 0,001-0,015 | de préférence 0,001-0,010 | plus préférablement 0,001-0,005 |
| Si | 0,01-0,5 | de préférence 0,01-0,4 | plus préférablement 0,01-0,3 |
| Mn | 0,02 à 0,5 | de préférence 0,02-0,4 | plus préférablement 0,02-0,3 |
| P | 0,1 max. | de préférence 0,05 max. | plus préférablement 0,05 max. |
| S | 0,05 max. | de préférence 0,03 max. | plus préférablement 0,03 max. |
| Al | 0,01 à 1,0 | de préférence 0,01-0,50 | plus préférablement 0,01-0,1 |
| Nb | 0,011 à 0,15 | de préférence 0,011-0,10 | plus préférablement 0,011-0,05 |
| Ti | 0,01 à 0,4 | de préférence 0,01-0,3 | plus préférablement 0,01-0,20 |

un ou plusieurs des éléments suivants en option :

Bore jusqu'à 100 ppm max. et / ou
Vanadium jusqu'à 0,4 % en poids et / ou
Zirconium jusqu'à 0,4 % en poids et / ou
Hafnium jusqu'à 0,5 % en poids et / ou
Wolfram jusqu'à 0,5 % en poids et / ou
Tantale jusqu'à 0,5 % en poids,
le reste étant constitué de fer et d'impuretés dues à la fusion.

2. Procédé selon la revendication 1, **caractérisé en ce qu'**un acier IF avec l'analyse suivante en % en poids est fondu :

| | | | |
|---|---|---|---|
| C | 0,001-0,015 | de préférence 0,001-0,010 | plus préférablement 0,001-0,005 |
| Si | 0,01-0,5 | de préférence 0,01-0,4 | plus préférablement 0,01-0,3 |

(suite)

| | | | |
|---|---|---|---|
| Mn | 0,02 à 0,5 | de préférence 0,02-0,4 | plus préférablement 0,02-0,3 |
| P | 0,1 max. | de préférence 0,05 max. | plus préférablement 0,05 max. |
| S | 0,05 max. | de préférence 0,03 max. | plus préférablement 0,03 max. |
| Al | 0,01 à 1,0 | de préférence 0,01-0,50 | plus préférablement 0,01-0,1 |
| Nb | 0,011 à 0,15 | de préférence 0,011-0,10 | plus préférablement 0,011-0,05 |
| Ti | 0,01 à 0,4 | de préférence 0,01-0,3 | plus préférablement 0,01-0,20 |

un ou plusieurs des éléments suivants en option :

Bore jusqu'à 100 ppm max. et / ou
Vanadium jusqu'à 0,4 % en poids et / ou
Zirconium jusqu'à 0,4 % en poids et / ou
Hafnium jusqu'à 0,5 % en poids et / ou
Wolfram jusqu'à 0,5 % en poids et / ou
Tantale jusqu'à 0,5 % en poids,
le reste étant constitué de fer et d'impuretés dues à la fusion.

3. Procédé selon la revendication 1 ou 2, **caractérisé en ce qu'**un acier IF avec l'analyse suivante en % en poids est fondu :

| | | | |
|---|---|---|---|
| C | 0,001 à 0,015 | de préférence 0,001-0,010 | plus préférablement 0,001-0,006 |
| Si | 0,01 à 0,5 | de préférence 0,01-0,4 | |
| Mn | 0,02 à 0,5 | | |
| P | 0,1 max. | de préférence 0,1 max. | plus préférablement 0,1 max. |
| S | 0,05 max. | de préférence 0,03 max. | plus préférablement 0,03 max. |
| Al | 0,015 à 1,0 | de préférence 0,015-0,5 | plus préférablement 0,015-0,10 |
| Nb | 0,02 à 0,15 | de préférence 0,021-0,10 | plus préférablement 0,021-0,05 |
| Ti | 0,01 à 0,2 | de préférence 0,01-0,15 | plus préférablement 0,01-0,12 |

un ou plusieurs des éléments suivants en option :

Bore jusqu'à 100 ppm max. et / ou
Vanadium jusqu'à 0,4 % en poids et / ou
Zirconium jusqu'à 0,4 % en poids et / ou
Hafnium jusqu'à 0,5 % en poids et / ou
Wolfram jusqu'à 0,5 % en poids et / ou
Tantale jusqu'à 0,5 % en poids et / ou
le reste étant constitué de fer et d'impuretés dues à la fusion.

4. Procédé selon l'une des revendications précédentes, **caractérisé en ce que**, après le dressage, la tôle d'acier est munie d'une couche anticorrosion métallique par un procédé électrolytique ou par dépôt en phase vapeur.

5. Procédé selon la revendication 4, **caractérisé en ce que** la couche anticorrosion métallique est appliquée par électrolyse ou par procédé CVD ou PVD, où le revêtement métallique est en zinc ou sur la base de zinc, en particulier un revêtement zinc-chrome, un revêtement zinc-nickel, un alliage zinc-magnésium, zinc-titane, zinc-calcium ou encore des alliages du zinc avec du zircone, du hafnium, du cérium ou encore en général des métaux mixtes ou des métaux de terres rares.

6. Procédé selon l'une des revendications précédentes, **caractérisé en ce que** les cylindres de dressage utilisés ont une rugosité (Ra) entre 1,6 et 3,3 pm.

7. Procédé selon l'une des revendications précédentes, **caractérisé en ce que** le degré de dressage est entre 0,5 et 0,75 %.

8. Procédé selon l'une des revendications précédentes, **caractérisé en ce que** le taux d'échauffement pourrait se situer entre 5 K/s et 30 K/s.

9. Tôle d'acier fabriquée par un procédé selon l'une des revendications précédentes d'une composition selon la revendication 2 ou la revendication 3.

10. Utilisation d'une tôle d'acier selon la revendication 9 pour le revêtement extérieur des véhicules automobiles et des bâtiments.

Fig. 1

Fig. 2

Wsa unbesch. verf.   ■ Wsa el. verzinkt verf.

Fig. 3

| | C | Si | Mn | P max. | S max. | Al | Nb | Ti |
|---|---|---|---|---|---|---|---|---|
| IF | 0,001 – 0,012 | 0,01 – 0,5 | 0,02 – 0,5 | 0,07 | 0,05 | 0,01 – 0,5 | 0,011– 0,15 | 0,01 – 0,4 |

Fig. 4

|    | C                      | Si          | Mn          | P max. | S max. | Al                    | Nb               | Ti          |
|----|------------------------|-------------|-------------|--------|--------|-----------------------|------------------|-------------|
| IF | 0,001 — 0,008          | 0,01 — 0,4  | 0,02 — 0,4  | 0,05   | 0,03   | 0,01 — 0,25           | 0,021– 0,10      | 0,01 — 0,3  |

Fig. 5

|    | C                      | Si          | Mn          | P max. | S max. | Al                    | Nb               | Ti          |
|----|------------------------|-------------|-------------|--------|--------|-----------------------|------------------|-------------|
| IF | 0,001 — 0,005          | 0,01 — 0,3  | 0,02 — 0,3  | 0,03   | 0,03   | 0,01 — 0,10           | 0,021– 0,050     | 0,01 — 0,2  |

Fig. 6

| K_DICKE mm | Schichtdicke Zn g/m2 | Aufheizrate K/s | Wsa(5%) µm unbeschichtet µm | C % | N % | B % | AL % | S % | NB % | TI % | N*(Ti+Nb)*S*10^6 | erfindungs gemäß |
|---|---|---|---|---|---|---|---|---|---|---|---|---|
| 0,75 | 47/47 | 8 | 0,3 | 0,0014 | 0,0046 | 0,0002 | 0,039 | 0,0036 | 0,002 | 0,058 | 0,9936 | nein |
| 0,70 | 53/53 | 7 | 0,32 | 0,0012 | 0,0042 | 0,0002 | 0,034 | 0,0039 | 0,002 | 0,059 | 0,99918 | nein |
| 0,70 | 47/47 | 5 | 0,42 | 0,0011 | 0,0046 | 0,0002 | 0,032 | 0,0042 | 0,002 | 0,049 | 0,98532 | nein |
| 0,75 | 47/47 | 8 | 0,36 | 0,0016 | 0,0035 | 0,0002 | 0,041 | 0,0038 | 0,002 | 0,066 | 0,9044 | nein |
| 0,75 | 53/53 | 9 | 0,33 | 0,0016 | 0,0035 | 0,0002 | 0,027 | 0,0038 | 0,002 | 0,061 | 0,8379 | nein |
| 0,70 | 53/53 | 7 | 0,29 | 0,0021 | 0,0045 | 0,0002 | 0,035 | 0,0079 | 0,021 | 0,044 | 2,31075 | ja |
| 0,75 | 53/53 | 6 | 0,27 | 0,0018 | 0,0041 | 0,0002 | 0,035 | 0,0079 | 0,021 | 0,044 | 2,10535 | ja |
| 0,75 | 53/53 | 6 | 0,27 | 0,0018 | 0,004 | 0,0002 | 0,039 | 0,0061 | 0,022 | 0,051 | 1,7812 | ja |
| 0,70 | 47/47 | 5 | 0,25 | 0,0017 | 0,0039 | 0,0002 | 0,040 | 0,007 | 0,022 | 0,046 | 1,77684 | ja |
| 0,70 | 53/53 | 4 | 0,23 | 0,0021 | 0,0045 | 0,0002 | 0,042 | 0,0065 | 0,022 | 0,053 | 2,19375 | ja |
| 0,70 | 47/47 | 7 | 0,26 | 0,0021 | 0,0046 | 0,0002 | 0,035 | 0,0058 | 0,021 | 0,054 | 2,001 | ja |
| 0,75 | 47/47 | 8 | 0,26 | 0,0021 | 0,0046 | 0,0002 | 0,035 | 0,0049 | 0,023 | 0,064 | 1,96098 | ja |
| 0,70 | 47/47 | 9 | 0,25 | 0,0021 | 0,0046 | 0,0002 | 0,04 | 0,0057 | 0,024 | 0,057 | 2,12382 | ja |
| 0,70 | 53/53 | 5 | 0,24 | 0,0018 | 0,004 | 0,0002 | 0,046 | 0,0074 | 0,027 | 0,039 | 1,9536 | ja |
| 0,70 | 53/53 | 6 | 0,24 | 0,0018 | 0,0041 | 0,0002 | 0,039 | 0,0074 | 0,027 | 0,055 | 2,48788 | ja |
| 0,75 | 47/47 | 5 | 0,22 | 0,0017 | 0,0039 | 0,0002 | 0,038 | 0,0065 | 0,029 | 0,048 | 1,95195 | ja |
| 0,75 | 53/53 | 7 | 0,22 | 0,0017 | 0,0039 | 0,0002 | 0,035 | 0,0065 | 0,030 | 0,062 | 2,3322 | ja |
| 0,70 | 53/53 | 6 | 0,22 | 0,0018 | 0,0041 | 0,0002 | 0,041 | 0,0059 | 0,031 | 0,054 | 2,05615 | ja |
| 0,70 | 53/53 | 5 | 0,22 | 0,0017 | 0,0039 | 0,0002 | 0,043 | 0,0058 | 0,031 | 0,059 | 2,0358 | ja |

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0234698 B1

**In der Beschreibung aufgeführte Nicht-Patentliteratur**

- *Neuartige Blechverzinkung bringt Automobillack auf Hochglanz,* 17. Oktober 2013, www.blechnet.com